# EUROPEAN PATENT APPLICATION

(11) **EP 4 647 838 A2**
(43) Date of publication of application: **12.11.2025**
(21) Application number: 25193624.1
(22) Date of filing: 04.08.2025
(51) Int. Cl.: G03F 7/00

(54) **CONTROL METHOD, POSITIONING SYSTEM, EXPOSURE APPARATUS AND DEVICE MANUFACTURING METHOD**

(71) Applicant: ASML Netherlands B.V., 5500 AH Veldhoven (NL)
(72) Inventor: MEESSEN, Koen Joseph, 5500 AH Veldhoven (NL); BUTLER, Hans, 5500 AH Veldhoven (NL)
(74) Representative: ASML Netherlands B.V.

(57) **Abstract**

A control method to control a position of a movable object is described, the method comprising:
providing a desired position of the movable object;
determining an actual position of the movable object;
providing an actuator control signal for one or more actuators to actuate the movable object, wherein the actuator control signal comprises a combination of a feedforward control signal and a feedback control signal,
determining a next feedforward control signal based on the desired position,
determining a next feedback control signal based on a difference between the actual position and the desired position of the movable object,
updating the actuator control signal with the next feedforward control signal and updating the actuator control signal with the next feedback control signal independently from each other.

## Description

### FIELD

The present invention relates to a control method to control a position of a movable object and a positioning system. The invention further relates to an exposure apparatus and a device manufacturing method.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") of a patterning device (e.g., a mask) onto a layer of radiation-sensitive material (resist) provided on a substrate (e.g., a wafer).

As semiconductor manufacturing processes continue to advance, the dimensions of circuit elements have continually been reduced while the amount of functional elements, such as transistors, per device has been steadily increasing over decades, following a trend commonly referred to as 'Moore's law'. To keep up with Moore's law the semiconductor industry is chasing technologies that enable to create increasingly smaller features. To project a pattern on a substrate a lithographic apparatus may use electromagnetic radiation. The wavelength of this radiation determines the minimum size of features which are patterned on the substrate. Typical wavelengths currently in use are 365 nm (i-line), 248 nm, 193 nm and 13.5 nm. A lithographic apparatus, which uses extreme ultraviolet (EUV) radiation, having a wavelength within a range of 4 nm to 20 nm, for example 6.7 nm or 13.5 nm, may be used to form smaller features on a substrate than a lithographic apparatus which uses, for example, radiation with a wavelength of 193 nm.

In known embodiments of a lithographic apparatus, positioning systems are used to position movable objects, for example a substrate support or a patterning device support, in a desired position. The positioning system may comprise a position measurement system to measure an actual position of the movable object and a control system to provide an actuator control signal for the one or more actuators based on the actual position and a desired position of the movable object.

The control system may comprise a feedforward controller and a feedback controller. The feedforward controller is configured to provide a feedforward control signal based on the desired position and the feedback controller is configured to provide a feedback control signal based on a difference between the desired position and the actual position of the movable object.

The positioning system may comprise one or more actuators to exert an actuation force on the movable object on the basis of the actuator control signal. The actuator control signal comprises a combination of the feedforward control signal and the feedback control signal.

The feedforward control signal and a feedback control signal are regularly updated. At a measurement sample time, one or more sensors of the position measurement system measure a sensor signal representative for an actual position of the movable object. This sensor signal is processed to determine the actual position of the movable object. This actual position is fed into the control system to determine the difference between the actual position and the desired position. The feedback controller will calculate the next feedback control signal based on this difference. Also, the feedforward controller will calculate the next feedforward control signal. At regular time intervals the combination of the next feedback control signal and the next feedforward control signal will be used to update the actuator control signal that is used to control the one or more actuators.

### SUMMARY

It is an object of the invention to provide a control method which may provide increased control performance in the position control of a movable object. It is another object of the invention to provide a positioning system that may enable improved control performance.

According to an aspect of the invention, there is provided a control method to control a position of a movable object, wherein the method comprises the steps of:
providing a desired position of the movable object;
determining an actual position of the movable object;
providing an actuator control signal for one or more actuators to actuate the movable object, wherein the actuator control signal comprises a combination of a feedforward control signal and a feedback control signal,
determining a next feedforward control signal based on the desired position,
updating the actuator control signal with the next feedforward control signal,
determining a next feedback control signal based on a difference between the actual position and the desired position of the movable object,
updating the actuator control signal with the next feedback control signal,
wherein updating the actuator control signal with the next feedforward control signal and updating the actuator control signal with the next feedback control signal are performed independently from each other.

According to an aspect of the invention, there is provided a positioning system to position a movable object, comprising:
one or more actuators to exert an actuation force on the movable object based on an actuator control signal,
a control system to provide the actuator control signal, wherein the actuator control signal comprises a combination of a feedforward control signal and a feedback control signal,
a position measurement system to determine an actual position of the movable object at a predetermined measurement time,
wherein the control system is arranged to
to determine a next feedforward control signal based on a desired position of the movable object,
to update the actuator control signal with the next feedforward control signal,
to determine a next feedback control signal based on a difference between the actual position and the desired position of the movable object, and
to update the actuator control signal with the next feedback control signal,
wherein updating the actuator control signal with the next feedforward control signal and updating the actuator control signal with the next feedback control signal are performed independently from each other.

According to an aspect of the invention, there is provided an exposure apparatus comprising a movable object, wherein the exposure apparatus comprises such positioning system.

According to an aspect of the invention, there is provided a device manufacturing method, comprising the steps of:
providing a radiation beam,
imparting the radiation beam with a pattern of a patterning device to provide a patterned radiation beam, and
projecting the patterned radiation beam on a substrate,
wherein the method comprises positioning of a movable object using a control method, wherein the method comprises the steps of:
   providing a desired position of the movable object;
   determining an actual position of the movable object;
   providing an actuator control signal for one or more actuators to actuate the movable object, wherein the actuator control signal comprises a combination of a feedforward control signal and a feedback control signal,
   determining a next feedforward control signal based on the desired position,
   updating the actuator control signal with the next feedforward control signal,
   determining a next feedback control signal based on a difference between the actual position and the desired position of the movable object,
   updating the actuator control signal with the next feedback control signal,
   wherein updating the actuator control signal with the next feedforward control signal and updating the actuator control signal with the next feedback control signal are performed independently from each other.

### BRIEF DESCRIPTION OF THE DRAWINGS

Embodiments of the invention will now be described, by way of example only, with reference to the accompanying schematic drawings, in which:
- Fig. 1 depicts a schematic overview of a lithographic apparatus;
- Fig. 2 depicts a detailed view of a part of the lithographic apparatus of Fig. 1 comprising a positioning system;
- Fig. 3 schematically depicts a known embodiment of a control scheme of a positioning system;
- Fig. 4 schematically depicts a first embodiment of a control scheme of a control method and/or positioning system according to the invention;
- Fig. 5 schematically depicts the timing of updating of the actuator control signal in the control scheme of Fig. 3;
- Fig. 6 schematically depicts the timing of updating of the actuator control signal in the control scheme of Fig. 4; and
- Fig. 7 schematically depicts a second embodiment of a control scheme of a control method and/or positioning system according to the invention.

### DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

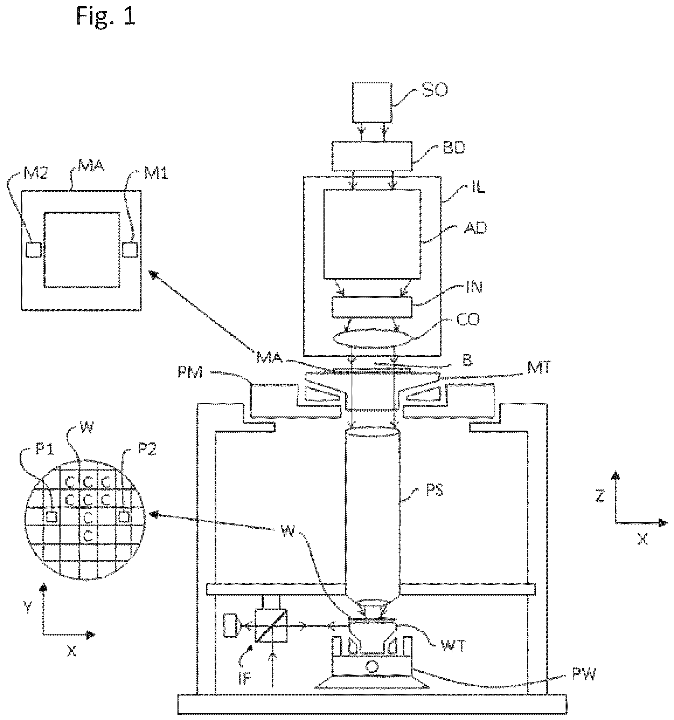

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the patterning device MA, the radiation beam B passes through the projection system PS, which focuses the beam onto a target portion C of the substrate W. With the aid of the second positioner PW and a position measurement system PMS, the substrate support WT can be moved accurately, e.g., so as to position different target portions C in the path of the radiation beam B at a focused and aligned position. Similarly, the first positioner PM and possibly another position sensor (which is not explicitly depicted in Fig. 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

To clarify the invention, a Cartesian coordinate system is used. The Cartesian coordinate system has three axis, i.e., an x-axis, a y-axis and a z-axis. Each of the three axis is orthogonal to the other two axis. A rotation around the x-axis is referred to as an Rx-rotation. A rotation around the y-axis is referred to as an Ry-rotation. A rotation around about the z-axis is referred to as an Rz-rotation. The x-axis and the y-axis define a horizontal plane, whereas the z-axis is in a vertical direction. The Cartesian coordinate system is not limiting the invention and is used for clarification only. Instead, another coordinate system, such as a cylindrical coordinate system, may be used to clarify the invention. The orientation of the Cartesian coordinate system may be different, for example, such that the z-axis has a component along the horizontal plane.

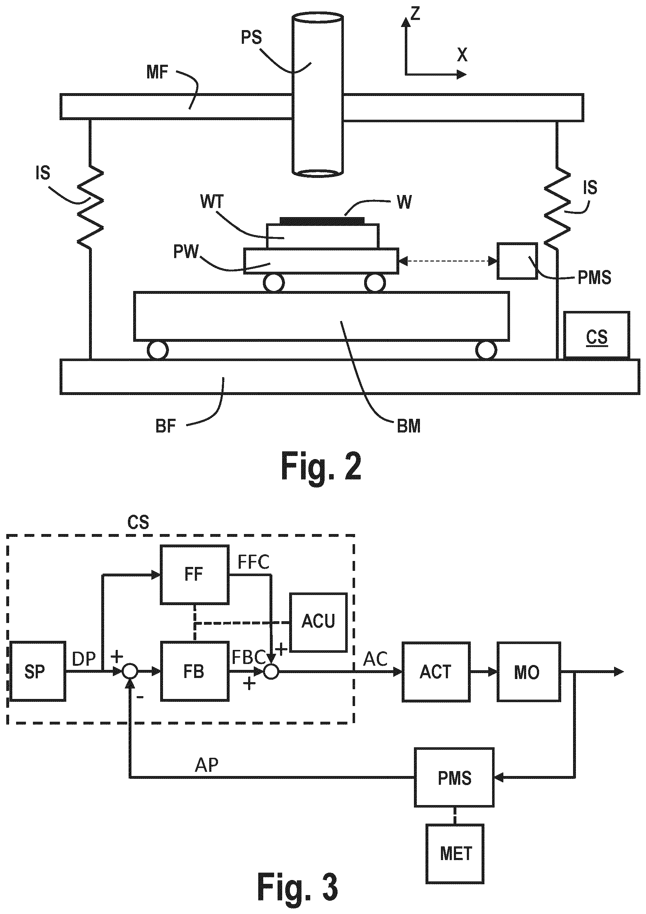

Fig. 2 shows a more detailed view of a part of the lithographic apparatus LA of Fig. 1. The lithographic apparatus LA may be provided with a base frame BF, a balance mass BM, a metrology frame MF and a vibration isolation system IS. The metrology frame MF supports the projection system PS. Additionally, the metrology frame MF may support a part of the position measurement system PMS. The metrology frame MF is supported by the base frame BF via the vibration isolation system IS. The vibration isolation system IS is arranged to prevent or reduce vibrations from propagating from the base frame BF to the metrology frame MF.

The second positioner PW is arranged to accelerate the substrate support WT by providing a driving force between the substrate support WT and the balance mass BM. The driving force accelerates the substrate support WT in a desired direction. Due to the conservation of momentum, the driving force is also applied to the balance mass BM with equal magnitude, but at a direction opposite to the desired direction. Typically, the mass of the balance mass BM is significantly larger than the masses of the moving part of the second positioner PW and the substrate support WT.

In an embodiment, the second positioner PW is supported by the balance mass BM. For example, wherein the second positioner PW comprises a planar motor to levitate the substrate support WT above the balance mass BM. In another embodiment, the second positioner PW is supported by the base frame BF. For example, wherein the second positioner PW comprises a linear motor and wherein the second positioner PW comprises a bearing, like a gas bearing, to levitate the substrate support WT above the base frame BF.
The position measurement system PMS may comprise any type of sensor that is suitable to determine a position of the substrate support WT. The position measurement system PMS may comprise any type of sensor that is suitable to determine a position of the mask support MT. The sensor may be an optical sensor such as an interferometer or an encoder. The position measurement system PMS may comprise a combined system of an interferometer and an encoder. The sensor may be another type of sensor, such as a magnetic sensor. a capacitive sensor or an inductive sensor. The position measurement system PMS may determine the position relative to a reference, for example the metrology frame MF or the projection system PS. The position measurement system PMS may determine the position of the substrate table WT and/or the mask support MT by measuring the position or by measuring a time derivative of the position, such as velocity or acceleration.
The position measurement system PMS may comprise an encoder system. An encoder system is known from for example, United States patent application US2007/0058173A1, filed on September 7, 2006, hereby incorporated by reference. The encoder system comprises an encoder head, a grating and a sensor. The encoder system may receive a primary radiation beam and a secondary radiation beam. Both the primary radiation beam as well as the secondary radiation beam originate from the same radiation beam, i.e., the original radiation beam. At least one of the primary radiation beam and the secondary radiation beam is created by diffracting the original radiation beam with the grating. If both the primary radiation beam and the secondary radiation beam are created by diffracting the original radiation beam with the grating, the primary radiation beam needs to have a different diffraction order than the secondary radiation beam. Different diffraction orders are, for example,+1^{st} order, -1^{st} order, +2^{nd} order and -2^{nd} order. The encoder system optically combines the primary radiation beam and the secondary radiation beam into a combined radiation beam. A sensor in the encoder head determines a phase or phase difference of the combined radiation beam. The sensor generates a signal based on the phase or phase difference. The signal is representative of a position of the encoder head relative to the grating. One of the encoder head and the grating may be arranged on the substrate structure WT. The other of the encoder head and the grating may be arranged on the metrology frame MF or the base frame BF. For example, a plurality of encoder heads are arranged on the metrology frame MF, whereas a grating is arranged on a top surface of the substrate support WT. In another example, a grating is arranged on a bottom surface of the substrate support WT, and an encoder head is arranged below the substrate support WT.

The position measurement system PMS may comprise an interferometer system. An interferometer system is known from, for example, United States patent US6,020,964, filed on July 13, 1998, hereby incorporated by reference. The interferometer system may comprise a beam splitter, a mirror, a reference mirror and a sensor. A beam of radiation is split by the beam splitter into a reference beam and a measurement beam. The measurement beam propagates to the mirror and is reflected by the mirror back to the beam splitter. The reference beam propagates to the reference mirror and is reflected by the reference mirror back to the beam splitter. At the beam splitter, the measurement beam and the reference beam are combined into a combined radiation beam. The combined radiation beam is incident on the sensor. The sensor determines a phase or a frequency of the combined radiation beam. The sensor generates a signal based on the phase or the frequency. The signal is representative of a displacement of the mirror. In an embodiment, the mirror is connected to the substrate support WT. The reference mirror may be connected to the metrology frame MF. In an embodiment, the measurement beam and the reference beam are combined into a combined radiation beam by an additional optical component instead of the beam splitter.

The first positioner PM may comprise a long-stroke module and a short-stroke module. The short-stroke module is arranged to move the mask support MT relative to the long-stroke module with a high accuracy over a small range of movement. The long-stroke module is arranged to move the short-stroke module relative to the projection system PS with a relatively low accuracy over a large range of movement. With the combination of the long-stroke module and the short-stroke module, the first positioner PM is able to move the mask support MT relative to the projection system PS with a high accuracy over a large range of movement. Similarly, the second positioner PW may comprise a long-stroke module and a short-stroke module. The short-stroke module is arranged to move the substrate support WT relative to the long-stroke module with a high accuracy over a small range of movement. The long-stroke module is arranged to move the short-stroke module relative to the projection system PS with a relatively low accuracy over a large range of movement. With the combination of the long-stroke module and the short-stroke module, the second positioner PW is able to move the substrate support WT relative to the projection system PS with a high accuracy over a large range of movement.

The first positioner PM and the second positioner PW each are provided with an actuator to move respectively the mask support MT and the substrate support WT. The actuator may be a linear actuator to provide a driving force along a single axis, for example the y-axis. Multiple linear actuators may be applied to provide driving forces along multiple axis. The actuator may be a planar actuator to provide a driving force along multiple axis. For example, the planar actuator may be arranged to move the substrate support WT in 6 degrees of freedom. The actuator may be an electromagnetic actuator comprising at least one coil and at least one magnet. The actuator is arranged to move the at least one coil relative to the at least one magnet by applying an electrical current to the at least one coil. The actuator may be a moving-magnet type actuator, which has the at least one magnet coupled to the substrate support WT respectively to the mask support MT. The actuator may be a moving-coil type actuator which has the at least one coil coupled to the substrate support WT respectively to the mask support MT. The actuator may be a voice-coil actuator, a reluctance actuator, a Lorentz-actuator or a piezo-actuator, or any other suitable actuator.

Fig. 3 shows a known embodiment of a control scheme of a positioning system to position a movable object MO of the lithographic apparatus LA. The movable object MO is for example a patterning device support MT or a substrate support WT.

The positioning system comprises a control system CS. The control system CS comprises a setpoint generator SP, a feedforward controller FF and a feedback controller FB. The setpoint generator SG provides a desired position DP of the movable object MO. The desired position may be a position or a position related quantity such as velocity, acceleration and other derivatives of the position.

The feedforward controller FF is configured to provide a feedforward control signal FFC based on the desired position DP of the movable object MO. The feedback controller FB is configured to provide a feedback control signal FBC based on a difference between the actual position AP and the desired position DP of the movable object MO. The actual position AP is obtained by a position measurement system PMS configured to determine the actual position of the movable object MO. The position measurement system PMS may be an interferometer system or an encoder system as described above, or any other position measurement system configured to measure the actual position of the movable object MO.

The feedforward control signal FFC and the feedback control signal FBC are combined in an actuator control signal AC for one or more actuators ACT. The actuators ACT are configured to exert an actuation force on the movable object MO to move the movable object MO to the desired position.

The actuator control signal AC may be a force based actuator control signal provided to a power amplifier (not separately shown) configured to convert the force based actuator control signal into a current based actuator control signal for power electronics of the power amplifier. This current based actuator control signal causes power electronics of the power amplifier to generate a current that is supplied to the one or more actuators ACT to move the movable object MO to the desired position. The one or more actuators ACT may for example comprise one or more Lorentz actuators.

The control system CS may comprise other elements or devices such as a decoupling device to decouple the feedforward control signal FFC and the feedback control signal FBC from control coordinates into actuation directions of the one or more actuators ACT.

Since the desired position DP and the actual position AP of the movable object will change over time, it is desired to regularly adjust the actuator control signal AC. Such adjustment of the actuator control signal AC will hereinafter also be referred to as updating of the actuator control signal AC.

In the known embodiment of the control scheme, the measurement of the actual position AP of the movable object MO is started at a sample time. In the control scheme, a measurement timer MET is drawn to show a timer that starts measurement of the actual position AP of the movable object MO. In practice, this measurement timer MET may be integrated in the position measurement system PMS, the control system CS, or another part of the positioning system.

Sensors of the position measurement system PMS will at the sample time determine one or more sensor signals representative for the position of the movable object MO. Based on the one or more sensor signals, the position measurement system PMS or the control system CS may calculate the actual position AP which is subsequently compared with the desired position DP provided by the setpoint generator SG.

The feedback controller FB will calculate a new feedback control signal FBC based on the newly calculated difference between the desired position DP and the measured actual position AP. The feedforward controller FF will also provide a new feedforward control signal FFC.

At an update time, the actuator control signal AC will be updated with the new feedforward control signal FFC and the new feedback control signal FBC. In Fig. 3 the control system CS comprises an actuator control signal update device ACU configured to time the update the actuator control signal AC with the new feedforward control signal FFC and the new feedback control signal FBC. The actuator control signal update device ACU is indicated as a separate block, but may in practice be integrated into the control system CS or another part of the positioning system. The actuator control signal update device ACU is in particular shown to visualize timing of the update of the actuator control signal AC.

Since a certain calculation time is needed to determine the new feedback control signal FBC, in particular for the steps of determining the actual position AP, the difference between the actual position AP and the desired position DP, and determining the new feedback control signal FBC, a certain time period is required between the sample time and the update time. This calculation time may differ for different measurements of the actual position AP of the movable object MO, for example due to controller parameters of the feedback controller FB, the number of calculations to obtain the new feedback control signal FBC can vary. Further, it is desirable to update the actuator control signal AC with a new control value of the feedforward signal at a regular time interval to provide stability of the delay between the sample time and the update time. To meet these requirements, the actuator control signal AC is updated at a regular time interval at a time period between the sample time and the update time longer than a maximum calculation time to determine the new feedback control signal FBC.

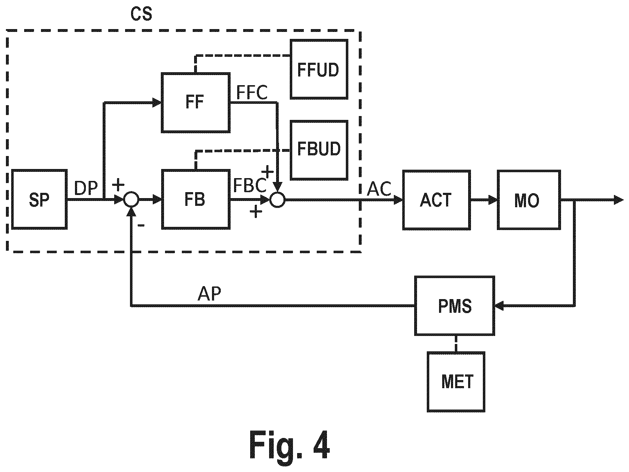

Fig. 4 shows a control scheme according to a first embodiment of a control method and/or positioning system of the invention. The control scheme of this embodiment comprises a separate feedforward control signal update device FFUD and a separate feedback control signal update device FBUD. The feedforward control signal update device FFUD is provided to time an update of the actuator control signal AC with a new feedforward control signal FFC. Correspondingly, the feedback control signal update device FBUD is provided to update the actuator control signal AC with a new feedback control signal FBC. As a result, updating the actuator control signal AC with the next feedforward control signal FFC and updating the actuator control signal AC with the next feedback control signal FBC may be performed independently in time from each other.

This has the advantage that the feedback control signal update device FBUD can be used to update the actuator control signal AC directly when the new feedback control signal FBC is available. Since the variation in the calculation time may substantially vary between different calculations, a substantial improvement in the feedback control performance, for example increased bandwidth, may be obtained when the actuator control signal AC is directly updated with the new feedback control signal FBC instead of waiting to a regular constant update time that is at least as long as the maximum calculation time of a new feedback control signal FBC. This increased bandwidth may reduce settle time of the movable object MO, and therewith improve throughput of a lithographic apparatus LA comprising such positioning system.

The actuator control signal AC may still be updated at regular time intervals with the next feedforward control signal FFC to ensure accurate timing of this update. The feedforward control forces may be large and also rapidly changing, for example during an acceleration phase of the movable object MO. A small timing error may introduce a significant positioning error.

As long as the update of the actuator control signal AC with the new feedback control signal FBC or with the new feedforward control signal FFC has not been performed, the control system CS may use the previous feedback control signal FBC or previous feedforward control signal FFC as part of the actual actuator control signal, respectively.

In the embodiment of Fig. 4 the control system CS is arranged to add the feedforward control signal FFC and the feedforward control signal FBC to provide a combined actuator control signal AC. In alternative embodiments, the feedforward control signal FFC and the feedback control signal FBC may also be outputted as separate signals from the control system CS and combined into the actuator control signal AC outside the control system CS, for example in a power amplifier of the one or more actuators ACT.

It is noted that the feedforward control signal update device FFUD and the feedback control signal update device FBUD are shown in the control scheme of Fig. 4 to visualize the presence of a device or system that controls the update of the actuator control signal AC with a new feedback control signal FBC or a next feedforward control signal FFC, respectively. Any other way of controlling the update of the actuator control signal AC with the next feedforward control signal FFC and/or the update of the actuator control signal AC with the next feedback control signal FBC independently from each other, may also be applied.

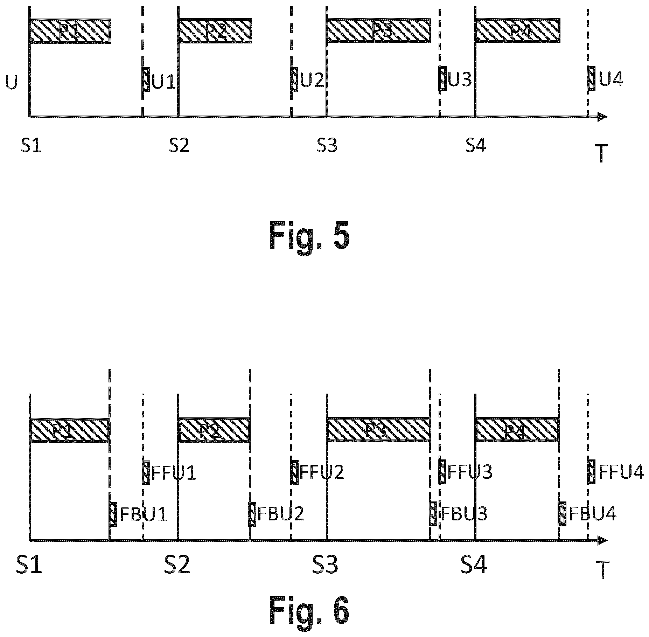

Figs. 5 and 6 show an example of the implementation of the known embodiment of the control scheme, as shown in Fig. 3, and the implementation of the control scheme of an embodiment according to the invention, as shown in Fig. 4, respectively.

Fig. 5 shows examples of the sample times S1-S4 at which position measurement is started, calculation periods P1-P4 needed to obtain the next feedback control signal FBC, and update times U1-U4 to update the actuation control signal AC with the next feedforward control signal FFC and the next feedback control signal FBC in the embodiment of Fig. 3. It can be seen that the sample times S1-S4 are at regular intervals and the update times U1-U4 are also at regular time intervals. The time periods between a sample time S1-S4 and an associated update time U1-U4 need to be at least as long as the calculation periods P1-P4 to ensure that the next feedback control signal FBC is available. The update times U1-U4 may therefore be selected on the basis of worst-case estimates of the required calculation periods P1-P4.

The calculation periods P1-P4 needed to obtain the next feedback control signal FBC may be different. There may be a substantial differences between the different calculation periods P1-P4. Further, there may be a substantial time period between the moment that a calculation period for the calculation of a next feedback control signal FBC is finished and the update time U1-U4 at which the actuator control signal AC is updated with the next feedback control signal FBC.

Fig. 6 shows examples of the sample times S1-S4 at which position measurement is started, calculation periods P1-P4 needed to obtain the next feedback control signal FBC, feedforward control signal update times FFU1-FFU4 to update the actuation control signal AC with the next feedforward control signal FFC and feedback control signal update times FBU1-FBU4 to update the actuation control signal AC with the next feedback control signal FBC in the embodiment of Fig. 4.

The sample times S1-S4 to start measurements of the position of the movable object MO and the calculation periods P1-P4 needed to obtain the next feedback control signal FBC are the same as shown in Fig. 5.

In the embodiment of Fig. 4, updating the actuator control signal AC with the next feedforward control signal FFC and updating the actuator control signal AC with the next feedback control signal FBC may be performed independently in time from each other. The update times of the feedforward control signal update device FFUD are indicated as feedforward control signal update times FFU1-FFU4 and the update times of the feedback control signal update device FBUD are indicated as feedback control signal update times FBU1-FBU4 in Fig. 6.

Corresponding to the example of Fig. 5, the feedforward control signal update times FFU1-FFU4 of Fig. 6 are scheduled at regular intervals to ensure accurate timing of the feedforward control signal FFC. The feedforward control signal update times FFU1-FFU4 may be at the same times as the actuator control signal updates U1-U4 of Fig. 5, but may also be timed at other regular time intervals. For example, the feedforward control signal update times FFU1-FFU4 may be timed later or sooner. It is noted that the feedforward control signal update times FFU1-FFU4 may also be timed sooner, since the feedforward control signal is not dependent on the actual position AP of the movable object MO. In an embodiment, the feedforward control signal update times FFU1-FFU4 may overlap/coincide with the calculation periods P1-P4 since the next feedforward control signal does not need to 'wait' for the calculation of the next feedback control signal FBC.

The feedback control signal update times FBU1-FBU4 may be directly after the calculation periods P1-P4 of the next feedback control signals FBC are finished. Thus, directly when a next feedback control signal FBC is available, the next feedback control signal FBC is used to update the actuator control signal AC with this next feedback control signal FBC. This may result in a substantial increase in feedback control performance of the movable object MO.

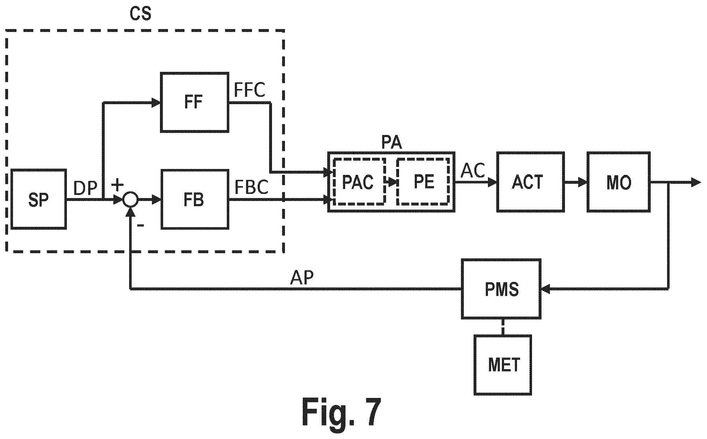

Fig. 7 shows a second embodiment of a control scheme of the control method and/or positioning system according to the invention. In this control scheme, a power amplifier PA is provided. The power amplifier PA is configured to convert force based actuator control signals into a current based actuator control signal AC provided by the power amplifier PA to the one or more actuators ACT.

The power amplifier PA comprises a power amplifier controller PAC and power electronics PE. The power amplifier controller PAC is configured to receive force based actuator control signals FFC and FBC and to convert these into a control signal for the power electronics PE of the power amplifier PA. This control signal causes the power electronics PE to generate a current based actuator control signal AC, i.e. one or more currents, that are supplied to the one or more actuators ACT.

In the embodiment of Fig. 7, the feedforward control signal FFC and the feedback control signal FBC are separately fed to the power amplifier controller PAC. The force based actuator control signal is thus a combination of two separate signals, a feedforward control signal FFC and a feedback control signal FBC.

The power amplifier controller PAC is configured to act as the feedforward control signal update device and the feedback control signal update device. This means that the power amplifier controller PAC will control the update of the current based actuator control signal AC with the next feedforward control signal FFC and the update of the current based actuator control signal AC with the next feedback control signal FBC. These updates may be performed independently from each other.

Since the power amplifier controller PAC is configured to update the current based actuator control signal AC with the new feedback control signal FBC and/or the next feedforward control signal FFC, the control system CS no longer comprises a feedforward control signal update device FFUD and a feedback control signal update device FBUD.

The power amplifier controller PAC may be configured to update the current based actuator control signal AC with the new feedback control signal FBC directly when the new feedback control signal FBC is available in order to increase control bandwidth. Also, the power amplifier controller PAC may be configured to update the current based actuator control signal AC with the new feedforward control signal FFC at regular intervals to ensure accurate timing of the feedforward control signal.

As long as the update of the current based actuator control signal AC with the new feedback control signal FBC or with the new feedforward control signal FFC has not been performed, the power amplifier controller PAC will use the previous feedback control signal FBC or feedforward control signal FFC, respectively.

Although specific reference may be made in this text to the use of a lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.
Although specific reference may have been made above to the use of embodiments of the invention in the context of optical lithography, it will be appreciated that the invention, where the context allows, is not limited to optical lithography and may be used in other applications, for example imprint lithography.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A control method to control a position of a movable object, wherein the method comprises the steps of:
providing a desired position of the movable object;
determining an actual position of the movable object;
providing an actuator control signal for one or more actuators to actuate the movable object, wherein the actuator control signal comprises a combination of a feedforward control signal and a feedback control signal,
determining a next feedforward control signal based on the desired position,
updating the actuator control signal with the next feedforward control signal,
determining a next feedback control signal based on a difference between the actual position and the desired position of the movable object,
updating the actuator control signal with the next feedback control signal,
wherein updating the actuator control signal with the next feedforward control signal and updating the actuator control signal with the next feedback control signal are performed independently from each other.

2. The control method of claim **1,** wherein updating the actuator control signal with the next feedforward control signal is performed based on accurately tracking a reference trajectory.

3. The control method of claim 1 or 2, wherein updating the actuator control signal with the next feedforward control signal is performed at a regular time interval.

4. The control method of any of the preceding claims, wherein updating the actuator control signal with the next feedback control signal is performed as soon as the next feedback control signal is available.

5. The control method of any of the preceding claims, wherein updating the actuator control signal with the next feedforward control signal is controlled by a feedforward control signal update device.

6. The control method of any of the preceding claims, wherein updating the actuator control signal with the next feedback control signal is controlled by a feedback control signal update device.

7. The control method of any of the preceding claims, wherein the method comprises
feeding the next feedforward control signal and the next feedback control signal separately to a power amplifier controller of a power amplifier, and
updating the actuator signal with the next feedforward control signal and/or updating the actuator control signal with the next feedback control signal in the power amplifier controller.

8. The control method of any of the preceding claims, wherein the method comprises converting the actuator control signal from a force based actuator control signal into a current based actuator control signal to be fed to the one or more actuators.

9. Positioning system to position a movable object, comprising:
one or more actuators to exert an actuation force on the movable object based on an actuator control signal,
a control system to provide the actuator control signal, wherein the actuator control signal comprises a combination of a feedforward control signal and a feedback control signal,
a position measurement system to determine an actual position of the movable object at a predetermined measurement time,
wherein the positioning system is arranged to
to determine a next feedforward control signal based on a desired position of the movable object,
to update the actuator control signal with the next feedforward control signal,
to determine a next feedback control signal based on a difference between the actual position and the desired position of the movable object, and
to update the actuator control signal with the next feedback control signal,
wherein updating the actuator control signal with the next feedforward control signal and
updating the actuator control signal with the next feedback control signal are performed independently from each other.

10. The positioning system of claim 9, wherein the control system is arranged to update the actuator control signal with the next feedforward control signal based on accurately tracking a reference trajectory.

11. The positioning system of claim 9 or 10, wherein the control system is arranged to update the actuator control signal with the next feedforward control signal at a regular time interval.

12. The positioning system of any of the preceding claims, wherein the control system is arranged to update the actuator control signal with the next feedback control signal is performed as soon as the next feedback control signal is available.

13. The positioning system of any of the preceding claims, wherein the positioning system comprises a feedforward control signal update device to update the actuator control signal with the next feedforward control signal and/or wherein the positioning system comprises a feedback control signal update device to update the actuator control signal with the next feedback control signal.

14. The positioning system of any of the preceding claims, wherein the positioning system comprises a power amplifier having a power amplifier controller, wherein the power amplifier controller is configured to control the update of the actuator control signal with the next feedforward control signal and/or to control the update of the actuator control signal with the next feedback control signal.

15. The positioning system of any of the preceding claims, wherein the control system comprises:
a setpoint generator to provide the desired position of the movable object,
a feedforward controller to determine the next feedforward control signal based on the desired position, and
a feedback controller to determine the next feedback control signal based on the difference between the actual position and the desired position of the movable object.

16. The positioning system of any of the preceding claims, wherein the positioning system comprises a power amplifier configured to convert a force based actuator control signal into a current based actuator control signal to be fed to the one or more actuators.

17. An exposure apparatus comprising a movable object, wherein the exposure apparatus comprises the positioning system of any of the claims 9-16 to position the movable object.

18. The exposure apparatus of claim 17, wherein the movable object is a patterning device support and/or a substrate support.

19. A device manufacturing method, comprising the steps of:
providing a radiation beam,
imparting the radiation beam with a pattern of a patterning device to provide a patterned radiation beam, and
projecting the patterned radiation beam on a substrate,
wherein the method comprises positioning of a movable object using the control method of any of the claims 1-8.

20. The device manufacturing method of claim 19, wherein the movable object is a patterning device support holding the patterning device and/or a substrate support holding the substrate.
